# EUROPÄISCHE PATENTSCHRIFT

(11) **EP 1 543 569 B1**
(45) Veröffentlichungstag und Bekanntmachung des Hinweises auf die Patenterteilung: **09.01.2008**
(21) Anmeldenummer: 03787689.3
(22) Anmeldetag: 19.07.2003
(51) Int. Cl.: H01L 45/00, H01L 27/24

(54) **NICHTFLÜCHTIGES SPEICHERELEMENT SOWIE ZUGEHÖRIGE HERSTELLUNGSVERFAHREN UND SPEICHERELEMENTANORDNUNGEN**
NON-VOLATILE MEMORY ELEMENT AND PRODUCTION METHODS THEREOF AND STORAGE MEMORY ARRANGEMENTS
ELEMENT DE MEMOIRE NON VOLATIL, PROCEDES DE PRODUCTION ASSOCIES ET ENSEMBLES A ELEMENT DE MEMOIRE

(30) Priorität: 26.07.2002 DE 10234660
(43) Veröffentlichungstag der Anmeldung: 22.06.2005
(73) Patentinhaber: Infineon Technologies AG, 81669 München (DE)
(72) Erfinder: BREUIL, Laurent, B-3010 Leuven (BE); SCHULER, Franz, 01109 Dresden (DE); TEMPEL, Georg, D-01277 Dresden (DE)
(74) Vertreter: Kindermann, Peter
(86) Internationale Anmeldenummer: PCT/DE2003/002434
(87) Internationale Veröffentlichungsnummer: WO 2004/017436

(56) Entgegenhaltungen:
- WO-A-90/00817
- WO-A-90/13921
- DE-B- 1 465 450
- GB-A- 1 083 154

## Beschreibung

Die vorliegende Erfindung bezieht sich auf ein nichtflüchtiges Speicherelement sowie zugehörige Herstellungsverfahren und Speicherelementanordnungen und insbesondere auf ein nichtflüchtiges Speicherelement mit einem Umschaltmaterial, bei dem nach einem Formierungs-Schritt zumindest zwei verschiedene Leitfähigkeitszustände realisiert werden und durch Anlegen vorbestimmter Programmierspannungen zwischen den Leitfähigkeitszuständen ein- oder mehrmals umgeschaltet werden kann.

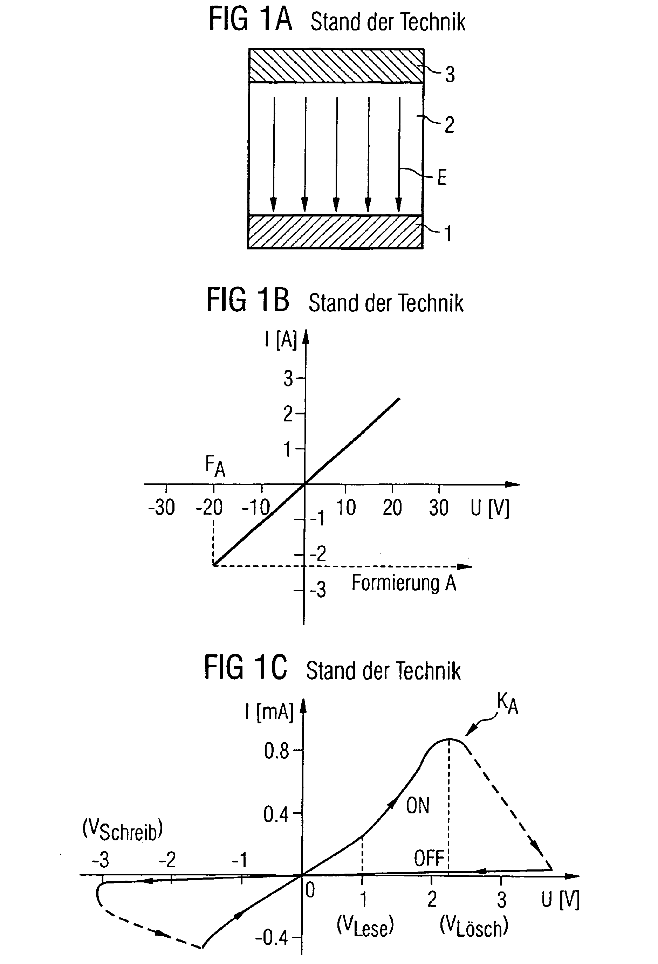

Die Figuren 1A bis 1C zeigen eine vereinfachte Schnittansicht bzw. vereinfachte U-I-Kennlinien eines gattungsgemäßen nichtflüchtigen Speicherelements, wie es beispielsweise aus der Druckschrift US 5,360,981 bekannt ist.

Gemäß Figur 1A besitzt ein derartiges nichtflüchtiges Speicherelement eine erste Elektrode 1, ein darauf ausgebildetes Umschaltmaterial 2 und eine zweite Elektrode 3, wobei zum Anlegen einer Spannung und zum Erzeugen eines elektrischen Feldes E die Elektroden 1 und 3 entsprechend beschaltet sind. Das Umschaltmaterial 2 besteht beispielsweise aus einem wasserstoffgesättigten amorphen Silizium-Halbleitermaterial (Hydrogenated Amorphous Silicon) welches eine p-Dotierung aufweist. Für die erste Elektrode 1 wird beispielsweise ein elektrisch leitendes Material und vorzugsweise Cr verwendet. Durch geeignete Auswahl für die zweite Elektrode 3 erhält man entweder analoges Umschaltverhalten für das Umschaltmaterial 2 oder digitales Umschaltverhalten. Bei Verwendung von V, Co, Ni und Tb erhält man gemäß Figur 1A beispielsweise analoges Umschaltverhalten, während für die Materialien Cr, W, oder Ag als zweite Elektrode 3 digitales Umschaltverhalten realisiert werden kann.

Kennzeichnend für derartige nichtflüchtige Speicherelemente ist insbesondere ein notwendiger und vorab durchgeführter Formierungs-Schritt (Forming), der die eigentlichen nichtflüchtigen Speichereigenschaften des Speicherelements erst ermöglicht.

Gemäß Figur 1B wird beispielsweise eine zunächst vorliegende lineare U-I-Kennlinie erst durch Anlegen einer Formierungs-Spannung F_{A} in einen Speicher-Kennlinienbereich gemäß Figur 1C umgewandelt. Derartige Formierungsspannungen F_{A} sind relativ hohe Spannungen und liegen üblicherweise in einem Bereich von 5 bis 30 Volt, wobei gemäß Figur 1B ein Formierungs-Schritt bei einer Formierungs-Spannung F_{A} = -20 V durchgeführt wird.

Demzufolge wird erst nach Durchführen dieses Formierungs-Schritts bzw. nach Anlegen dieser Formierungs-Spannung F_{A} im Umschaltmaterial 2 ein Kennlinienfeld K_{A} erzeugt, welches nichtflüchtige Speichereigenschaften und beispielsweise die in Figur 1C dargestellten zwei Leitfähigkeitszustände bzw. Kennlinienäste ON und OFF aufweist. Bei dem in Figur 1C dargestellten Kennlinienfeld K_{A} wurden als Elektrodenmaterial Cr und als Umschaltmaterial 2 wasserstoffgesättigtes amorphes Silizium mit p-Dotierung verwendet.

Anhand dieses nach dem Formierungs-Schritt gewonnenen komplexen Kennlinienfelds K_{A} gemäß Figur 1C kann nunmehr ein eigentliches nichtflüchtiges Speicherverhalten realisiert werden, wobei durch Anlegen entsprechender Betriebsspannungen die Leitfähigkeitszustände ON und OFF in Pfeilrichtung durchfahren werden.

Genauer gesagt kann beispielsweise ein den Leitfähigkeitszustand ON aufweisendes Umschaltmaterial 2 dadurch umprogrammiert werden, dass eine Programmierspannung V_{lösch} von ca. 2,5 Volt angelegt wird, wodurch der Leitfähigkeitszustand bzw.

Kennlinienast ON in den weiteren Leitfähigkeitszustand bzw. Kennlinienast OFF schaltet. In gleicher Weise kann durch Anlegen einer weiteren Programmierspannung V_{schreib} von beispielsweise -3 V wiederum der Leitfähigkeitszustand ON im Umschaltmaterial 2 erzeugt werden. Auf diese Weise kann zwischen den beiden Leitfähigkeitszuständen ON und OFF im Kennlinienfeld K_{A} hin und her geschaltet werden bzw. eine Programmierung erfolgen, wobei jeweilige Lesespannungen Vₗₑₛₑ unterhalb der Programmierspannungen und gemäß Figur 1C beispielsweise 1 Volt aufweisen. Da sich das Kennlinienfeld K_{A} bzw. die einmal programmierten Leitfähigkeitszustände ON und OFF in derartigen Umschaltmaterialien 2 nicht ändern, erhält man somit unter Auswertung eines zugehörigen Lesestroms ein nichtflüchtiges Speicherelement.

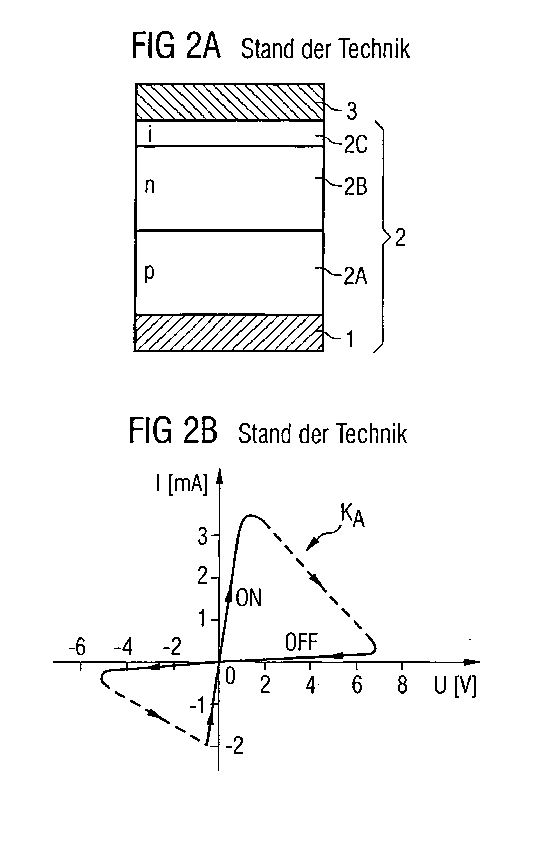

Figur 2A zeigt eine vereinfachte Schnittansicht eines weiteren herkömmlichen nichtflüchtigen Speicherelements, wobei jedoch das Umschaltmaterial aus einer Mehrfach-Schichtenfolge besteht. Genauer gesagt ist auf einer ersten Elektrode 1 beispielsweise ein p-dotiertes wasserstoffgesättigtes amorphes Silizium 2A ausgebildet, an dessen Oberfläche sich eine n-dotierte wasserstoffgesättigte amorphe Siliziumschicht 2B anschließt. Zur zweiten Elektrode 3 besitzt das Umschaltmaterial 2 ferner ein nicht dotiertes wiederum wasserstoffgesättigtes amorphes Silizium, wodurch man eine sogenannte p-n-i-Struktur erhält. Derartige nichtflüchtige Speicherelemente haben zwar den Vorteil, dass die Elektrodenmaterialien weniger kritisch insbesondere für p-dotierte Halbleitermaterialien sind, die Spannungen für den notwendigen Formierungs-Schritt sind jedoch sogar noch höher als beim Umschaltmaterial gemäß Figur 1A, weshalb sie für eine Massenproduktion von nichtflüchtigen Speichern bisher nicht in Betracht gezogen wurden.

Figur 2B zeigt ein vereinfachtes Kennlinienfeld K_{A} wiederum nach einem durchgeführten Formierungs-Schritt, woraus sich eine verbesserte Programmierung auf Grund des höheren Abstandes zwischen den unterschiedlichen Leitfähigkeitszuständen ON und OFF ergibt.

Das Dokument WO 90/00817 A beschreibt ein weiteres gattungsgemäßes nichtflüchtiges Speicherelement, wobei zur Reduktion der Formier-Spannung und -Energie ein n- oder p-dotierter Schichtbereich zwischen Umschaltmaterial und Elektrode oder im Umschaltmaterial selbst gebildet wird.

Der Erfindung liegt daher die Aufgabe zu Grunde ein nichtflüchtiges Speicherelement sowie zugehörige Herstellungsverfahren und Speicherelementanordnungen zu schaffen, mit dem eine Integration in herkömmliche Halbleiterschaltungen realisiert werden kann. Insbesondere liegt der Erfindung die Aufgabe zu Grunde den zum Ausbilden des nichtflüchtigen Speicherverhaltens notwendigen Formierungs-Schritt zu optimieren.

Erfindungsgemäß wird diese Aufgabe hinsichtlich des nichtflüchtigen Speicherelements durch die Merkmale des Patentanspruchs 1 gelöst. Hinsichtlich des Verfahrens wird diese Aufgabe durch die Maßnahmen des Patentanspruchs 8 gelöst und hinsichtlich der Speicherelementanordnungen wird diese Aufgabe durch die Merkmale der Patentansprüche 22 bis 24 gelöst.

Insbesondere durch die Verwendung von zumindest einer Feldverstärkerstruktur an zumindest einer der Elektroden zum Verstärken einer Feldstärke des elektrischen Feldes im Umschaltmaterial können die für den Formierungs-Schritt notwendigen - jedoch sehr hohen - Spannungen wesentlich reduziert werden, wodurch diese Speicherelemente erstmals mit herkömmlichen Halbleiterschaltungen wie z.B. CMOS-Schaltungen verknüpft bzw. kombiniert ausgebildet werden können.

Vorzugsweise stellt die Feldverstärkerstruktur einen in das Umschaltmaterial ragenden Vorsprung der Elektroden wie z.B. eine Spitze, eine Ecke oder Kante dar, wobei ein Winkel vorzugsweise ≤ 90 Grad ist. Auf diese Weise können notwendige Feldspitzen bzw. Felderhöhungen besonders einfach in integrierten nichtflüchtigen Speicherelementen ausgebildet werden.

Vorzugsweise bestehen das Umschaltmaterial aus einem wasserstoffgesättigten amorphen Halbleitermaterial, wobei auch

Mehrschichtstrukturen verwendbar sind, und die Elektroden vorzugsweise aus metallischen Materialien.

Hinsichtlich des Verfahrens zur Herstellung eines nichtflüchtigen Speicherelements wird insbesondere eine Vertiefung in einer Hilfsschicht ausgebildet und zum Ausbilden der ersten Elektroden diese Vertiefung mit einem ersten elektrisch leitenden Material ausgefüllt, wodurch in nachfolgenden Schritten die Feldverstärkerstruktur besonders einfach ausgebildet werden kann.

Vorzugsweise wird hierbei das elektrisch leitende Material derart abgeschieden, dass sich im Bereich der Vertiefung eine angepasste Vertiefung ergibt, wobei mittels eines anisotropen Ätzverfahrens das elektrisch leitende Material zumindest bis zu Oberfläche der Hilfsschicht konformal zurückgeätzt wird und mittels eines anisotropen Ätzverfahrens die Hilfsschicht im Wesentlichen bis zum Bodenbereich der angepassten Vertiefung zurückgeätzt wird. Auf diese Weise werden an der ersten Elektrode scharfe Spitzen ausgebildet, die zu der erwünschten Felderhöhung und somit zur Verringerung der Formierungs-Spannung führen.

Alternativ kann jedoch auch mittels eines Polierverfahrens das elektrisch leitende Material zumindest bis zur Oberfläche der Hilfsschicht zurückgebildet und mittels eines anschließenden selektiven Ätzverfahrens die Hilfsschicht um einen vorbestimmten Betrag zurückgeätzt werden, wodurch man wiederum sehr scharfe Kanten bzw. Ecken an der ersten Elektrode erhält, die zur erwünschten Feldverstärkung bzw. Felderhöhung führen.

Gemäß einer weiteren Alternative kann mittels eines Ätzverfahrens zumindest ein vorbestimmter Betrag des elektrisch leitenden Materials in der Vertiefung entfernt werden, anschließend eine dünne konformale elektrisch leitende Schicht derart ausgebildet werden, dass eine angepasste Vertiefung im Bereich der Vertiefung entsteht und abschließend mittels eines anisotropen Ätzverfahrens bzw. mittels eines Spacerverfahrens die elektrisch leitende Schicht zumindest bis zur Oberfläche der Hilfsschicht zurückgeätzt wird. Nach einem weiteren Rückätzschritt mittels eines anisotropen Ätzverfahrens der Hilfsschicht im Wesentlichen bis zum Bodenbereich der angepassten Vertiefung erhält man wiederum eine durch die Spacerstruktur hervorgerufene Feldverstärkerstruktur bzw. Feldüberhöhung im elektrischen Feld des Umschaltmaterials, wodurch sich die notwendigen Formierungs-Spannungen wesentlich reduzieren lassen.

Hinsichtlich der Speicherelementanordnung werden die nichtflüchtigen Speicherelemente matrixförmig angeordnet und über spaltenförmig angeordnete Bitleitungen und zeilenförmig angeordnete Wortleitungen angesteuert, wobei eine jeweilige erste Elektrode des Speicherelements unmittelbar über einen ohmschen Übergang oder einen Diodenübergang mit einer jeweiligen in einem Halbleitersubstrat ausgebildeten Wortleitung elektrisch verbunden ist und eine jeweilige zweite Elektrode zum Ausbilden einer jeweiligen Bitleitung streifenförmig an der Oberfläche des Halbleitersubstrats strukturiert ist.

Alternativ kann jedoch in einer Speicherelementanordnung für jedes nichtflüchtige Speicherelement einen Auswahltransistor mit einer als Steuerschicht dienenden Wortleitung und einer als erstes Source-/Draingebiet dienenden Bitleitung im Halbleitersubstrat ausgebildet werden, wobei ein zweites Source-/Draingebiet des Auswahltransistors mit einer jeweiligen ersten Elektrode des Speicherelements elektrisch verbunden ist. Dadurch erhält man ebenfalls eine neuartige und hochintegrierte nichtflüchtige Speicherelementanordnung.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
Figuren 1A bis 1C eine vereinfachte Schnittansicht sowie vereinfachte U-I-Kennlinienfelder eines nichtflüchtigen Speicherelements gemäß dem Stand der Technik;
Figuren 2A und 2B eine vereinfachte Schnittansicht und ein vereinfachtes U-I-Kennlinienfeld eines weiteren nichtflüchtigen Speicherelements gemäß dem Stand der Technik;
Figuren 3A bis 3C eine vereinfachte Schnittansicht sowie vereinfachte U-I-Kennlinienfelder eines nichtflüchtigen Speicherelements gemäß einem ersten Ausführungsbeispiel;
Figuren 4A und 4B eine vereinfachte Schnittansicht und ein vereinfachtes U-I-Kennlinienfeld eines nichtflüchtigen Speicherelements gemäß einem zweiten Ausführungsbeispiel;
Figuren 5A bis 5E vereinfachte Schnittansichten zur Veranschaulichung wesentlicher Verfahrensschritte bei der Herstellung eines nichtflüchtigen Speicherelements gemäß einem dritten Ausführungsbeispiel;
Figuren 6A bis 6C vereinfachte Schnittansichten zur Veranschaulichung wesentlicher Verfahrensschritte bei der Herstellung eines nichtflüchtigen Speicherelements gemäß einem vierten Ausführungsbeispiel;
Figuren 7A bis 7D vereinfachte Schnittansichten zur Veranschaulichung wesentlicher Verfahrensschritte bei der Herstellung eines nichtflüchtigen Speicherelements gemäß einem fünften Ausführungsbeispiel;
Figuren 8A und 8B ein vereinfachtes Ersatzschaltbild einer Speicherelementanordnung sowie eine vereinfachte Schnittansicht eines zugehörigen nichtflüchtigen Speicherelements gemäß einem sechsten Ausführungsbeispiel;
Figuren 9A und 9B ein vereinfachtes Ersatzschaltbild einer Speicherelementanordnung sowie eine vereinfachte Schnittansicht eines zugehörigen nichtflüchtigen Speicherelements gemäß einem siebten Ausführungsbeispiel; und
Figuren 10A und 10B ein vereinfachtes Ersatzschaltbild einer Speicherelementanordnung sowie eine vereinfachte Schnittansicht eines zugehörigen nichtflüchtigen Speicherelements gemäß einem achten Ausführungsbeispiel.

Die Erfindung wird nachstehend anhand eines vereinfachten nichtflüchtigen Speicherelements auf der Grundlage eines Speicherelements gemäß Figur 1A beschrieben, wobei gleiche Bezugszeichen gleiche oder entsprechende Schichten oder Elemente bezeichnen und auf eine wiederholte Beschreibung nachfolgend verzichtet wird. Insbesondere sei jedoch darauf hingewiesen, dass das Umschaltmaterial 2 in gleicher Weise auch einen Mehrschichtaufbau aufweisen kann, wobei insbesondere amorphe Halbleitermaterialien mit unterschiedlicher Dotierung in Frage kommen.

### Erstes Ausführungsbeispiel

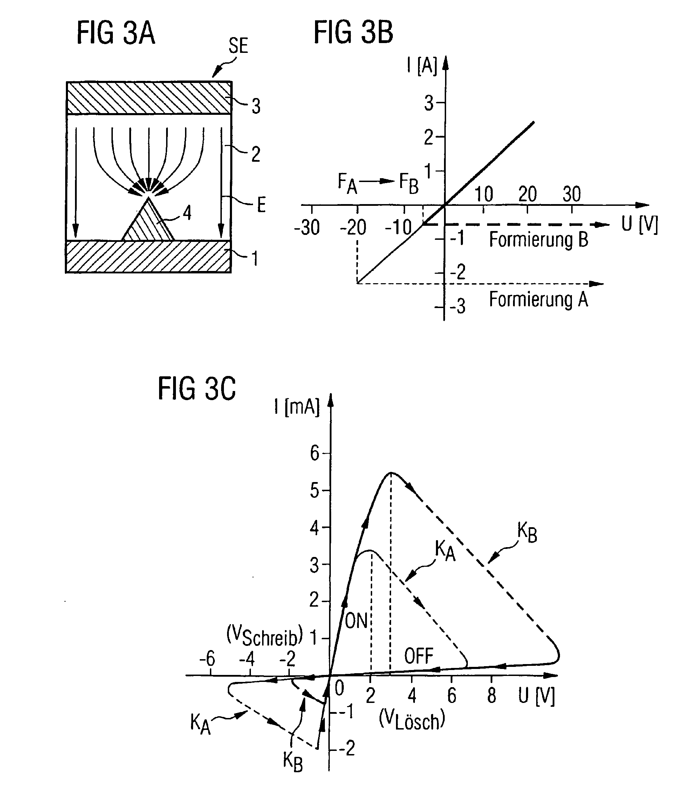

Gemäß Figur 3A besteht das nichtflüchtige Speicherelement SE gemäß einem ersten Ausführungsbeispiel wiederum aus einem Umschaltmaterial 2 und zwei am Umschaltmaterial 2 anliegenden elektrisch leitenden Elektroden 1 und 3, an die eine elektrische Spannung angelegt und eine elektrisches Feld E im Umschaltmaterial 2 erzeugt werden kann. Das Umschaltmaterial 2 besitzt hierbei wiederum die speziellen Eigenschaften, wobei nach einem Formierungs-Schritt zumindest zwei verschiedene Leitfähigkeitszustände vorherrschen, zwischen denen durch Anlegen vorbestimmter Programmierspannungen wiederholt umgeschaltet werden kann.

Vorzugsweise wird als Umschaltmaterial 2 wasserstoffgesättigtes amorphes Silizium oder ein entsprechender Mehrschichtaufbau verwendet, wobei das amorphe Silizium beispielsweise mittels des sogenannten Glüh-Entladungsverfahrens (Glow Discharge Technique) vorbereitet wird. Ferner bestehen die erste Elektrode 1 und die zweite Elektrode 3 aus einem geeigneten elektrisch leitenden Material, welches vorzugsweise ein Metall aufweist.

Eine beispielhafte Auflistung von möglichen Materialien für die erste und zweite Elektrode 1 und 3 sowie für das Umschaltmaterial 2 wird nachfolgend angegeben, wobei auch andere Materialien grundsätzlich denkbar sind:

| | | |
|---|---|---|
| Erste Elektrode | Umschaltmaterial | Zweite Elektrode |
| Rostfreier Stahl | p-n-i-dotiertes a-Si:H | Au oder Al |
| Rostfreier Stahl | p-n-i-dotiertes a-Si:H | Au oder Al oder NiCr |
| Cr | p-n-i-dotiertes a-Si:H oder n-p-i-dotiertes a-Si:H oder p-i-n-dotiertes Si:H | Al oder Cr |
| Cr | p-dotiertes a-Si:H | V |
| Cr | p-dotiertes a-Si:H | Ag, Al, Cr, Mn, Fe, W, V, Ni, Co, Mo, Pd |
| Cr | a-SiC:H | Ni |
| Cr | a-SiN:H oder a-SiC:H | Ni oder Mo |
| A1 | Tetrahedral-amorpher Kohlenstoff | Al |
| Elektrochemische Inert-Katode | Calzogenides Glas mit bis zu 30% Ag | Oxidierbares Ag (Anode) |
| Indium-TiN-Oxid | Konjugierte Polymere | Al |
| Metall | Calzogenide Legierung | Metall |

Die im Umschaltmaterial 2 auftretenden Vorgänge sind bislang nicht vollständig geklärt, wobei jedoch insbesondere bei Verwendung von amorphem Silizium davon ausgegangen wird, dass sich im Umschaltmaterial elektrisch leitende bzw. Metall-Filamente (filaments) innerhalb des amorphen Materials bei Anlegen einer vorbestimmten Spannung ausbilden, die bei Anlegen einer umgekehrten Spannung und/oder eines umgekehrten Stroms zerstört werden.

Wesentlich für die vorliegende Erfindung ist nunmehr, dass zumindest eine der Elektroden 1 oder 3 zumindest eine Feldverstärkerstruktur 4 zum Verstärken einer Feldstärke des elektrischen Feldes E im Umschaltmaterial 2 aufweist. Gemäß Figur 3A ist demnach an der ersten Elektrode 1 eine Spitze 4 als Feldverstärkerstruktur ausgebildet, die zu einer wesentlichen Verstärkung des im Umschaltmaterial 2 vorherrschenden elektrischen Feldes E führt. Auf Grund dieser Feldverstärkung ergeben sich Feldspitzen im Umschaltmaterial 2, die insbesondere den eingangs erwähnten Formierungs-Schritt günstig beeinflussen.

Gemäß Figur 3B wird demzufolge bei einem nichtflüchtigen Speicherelement SE mit der in Figur 3A dargestellten Feldverstärkerstruktur 4 die üblicherweise notwendige Formierungs-Spannung F_{A} von ca. -20 V auf beispielsweise eine verringerte Formierungs-Spannung F_{B} von beispielsweise -5 V verschoben, wodurch man in einen Spannungsbereich gelangt, wie er beispielsweise in herkömmlichen CMOS-Halbleiterschaltungen zur Verfügung steht. Genauer gesagt wird durch die im nichtflüchtigen Speicherelement ausgebildete Feldverstärkerstruktur 4 erstmals eine Integration dieses Bauelements mit herkömmlichen Halbleiterbauelementen ermöglicht, die in einem Spannungsbereich unterhalb von 10 Volt und vorzugsweise unterhalb von 5 Volt arbeiten. Ansteuerschaltungen für die notwendigen Betriebsspannungen können somit vereinfacht und ein Leistungsverbrauch kann dadurch wesentlich verringert werden.

Gemäß Figur 3C besitzt das nichtflüchtige Speicherelement SE bzw. dessen Umschaltmaterial 2 nach dem Formierungs-Schritt, der nunmehr eine wesentlich geringere Formierungs-Spannung F_{B} aufweist, ein modifiziertes Kennlinienfeld K_{B}. Hierbei ist mit K_{A} ebenfalls ein Kennlinienfeld gemäß dem Stand der Technik dargestellt. Demzufolge wird mit der auf der ersten Elektrode 1 ausgebildeten Feldverstärkerstruktur 4 nicht nur eine Formierungs-Spannung verringert, sondern auch ein Kennlinienfeld des Umschaltmaterials 2 bzw. des nichtflüchtigen Speicherelements SE verändert. Genauer gesagt wird auf Grund der einseitigen Feldverstärkung das Kennlinienfeld von K_{A} nach K_{B} im negativen Spannungsbereich gestaucht, während es im positiven Spannungsbereich auf Grund der umgekehrten Vorzeichens gestreckt wird.

Dies hat zur Folge, dass nicht nur die Formierungs-Spannung verringert werden kann, sondern auch die Programmierspannungen V_{lösch} und V_{schreib} an jeweilige Rahmenbedingungen angepasst werden können.

### Zweites Ausführungsbeispiel

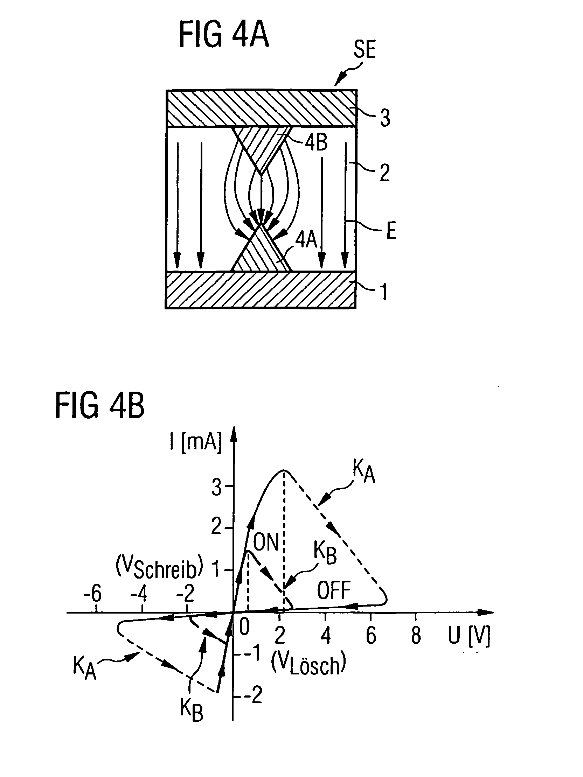

Figur 4A und 4B zeigen eine vereinfachte Schnittansicht sowie ein zugehöriges U-I-Kennlinienfeld gemäß einem zweiten Ausführungsbeispiel, wobei gleiche Bezugszeichen gleiche oder entsprechende Elemente bzw. Schichten bezeichnen und auf eine wiederholte Beschreibung nachfolgend verzichtet wird.

Gemäß Figur 4A wird nunmehr nicht nur an der ersten Elektrode 1 eine Spitze 4A, sondern auch an der zweiten Elektrode 3 eine entsprechende der Spitze 4A gegenüber liegende Spitze 4B als Feldverstärkerstruktur ausgebildet, wodurch eine Feldverstärkung in beiden Richtungen, d.h. positiver und negativer Spannung, erzeugt werden kann. Wiederum ergibt sich durch diese Feldverstärkerstruktur 4A und 4B im nichtflüchtigen Speicherelement SE eine Verringerung der Formierungs-Spannung, wobei sich gemäß Figur 4B nunmehr auch eine Stauchung der Kennlinienfelder von K_{A} nach K_{B} im positiven Spannungsbereich ergibt. Demzufolge können nicht nur die Programmierspannungen V_{schreib} zum Schreiben bzw. zum Umschalten des Leitfähigkeitszustands von OFF nach ON verringert werden, sondern auch die Programmierspannungen V_{lösch} zum Löschen des nichtflüchtigen Speicherelements SE bzw. zum Umschalten vom ON-Leitfähigkeitszustand zum OFF-Leitfähigkeitszustand. Neben der wesentlich verringerten Formierungs-Spannung F_{B} zum Erzeugen des nicht flüchtigen Speicherverhaltens im Umschaltmaterial 2 bzw. nicht flüchtigen Speicherelement SE erhält man durch die Feldverstärkerstruktur auch eine Anpassung des Kennlinienfeldes und insbesondere eine Verringerung der notwendigen Schreib- und Lösch-Spannungen. Auf diese Weise können daher völlig neuartige nichtflüchtige Speicher mit wesentlich verringerten Betriebsspannungen und stark verbessertem Strom- bzw. Leistungsverbrauch realisiert werden.

Gemäß dem ersten und zweiten Ausführungsbeispiel wurde als Feldverstärkerstruktur eine Spitze an der ersten Elektrode 1 und/oder der zweiten Elektrode 3 ausgebildet. Es können jedoch in gleicher Weise auch andere Vorsprünge der Elektroden 1 und 3 wie z.B. ausgebildete Ecken oder Kanten als Feldverstärkerstrukturen verwendet werden, sofern sie in das Umschaltmaterial 2 hineinragen und darin eine Feldstärke des elektrischen Feldes E zumindest lokal verstärken. Vorzugsweise weist ein Winkel der Spitzen, Ecken oder Kanten in den Elektroden 1 und 3 einen spitzen Winkel, d.h. einen Winkel ≤ 90 Grad auf, wodurch lokale Feldspitzen besonders einfach realisiert werden können. Zur besonders einfachen und kostengünstigen Realisierung bieten sich jedoch insbesondere die nachfolgend beschriebenen Verfahren an.

### Drittes Ausführungsbeispiel

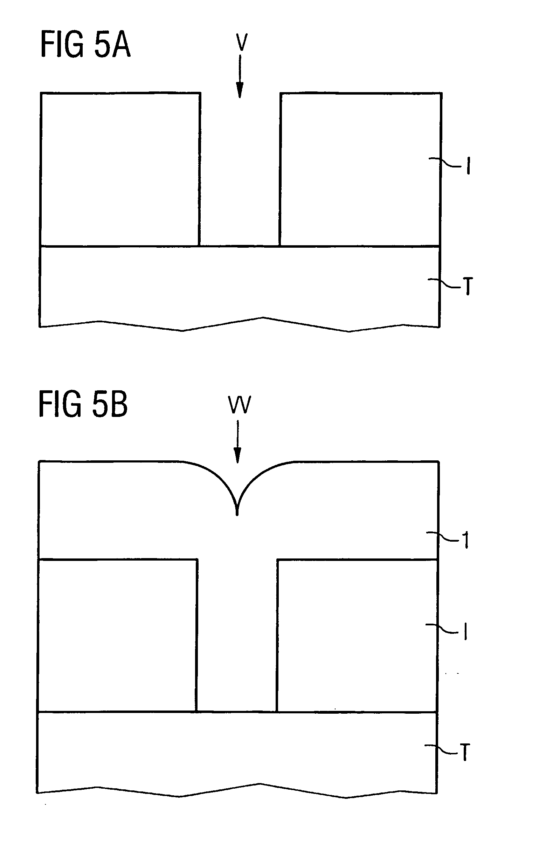

Figuren 5A bis 5E zeigen vereinfachte Schnittansichten zur Veranschaulichung wesentlicher Verfahrensschritte bei der Herstellung eines nichtflüchtigen Speicherelements gemäß einem dritten Ausführungsbeispiel, wobei gleiche Bezugszeichen gleiche oder entsprechende Elemente oder Schichten bezeichnen und auf eine wiederholte Beschreibung nachfolgend verzichtet wird.

Gemäß Figur 5A wird zunächst auf einem Trägermaterial T eine Hilfsschicht I ausgebildet und darin eine Vertiefung V erzeugt. Vorzugsweise wird als Trägermaterial T ein Halbleitersubstrat (Si) verwendet, in dem beispielsweise bereits aktive Gebiete mittels STI-Verfahren (Shallow Trench Isolation) sowie Dotierwannen ausgebildet sind und/oder bereits vollständige oder teilfertige Halbleiterbauelemente existieren. Selbstverständlich können neben dem bevorzugten Silizium-Halbleitersubstrat auch andere Trägermaterialien wie SOI- oder Siliziumoxid, Silicon on Saphir usw. verwendet werden.

Als Hilfsschicht I wird vorzugsweise eine dielektrische Schicht bzw. Isolatorschicht ganzflächig auf dem Trägermaterial T abgeschieden und mit der Vertiefung V versehen, wobei jedoch auch alternative Materialien und sogar elektrisch leitende Materialein verwendet werden können.

Beim Ausbilden der Vertiefung V, die beispielsweise einen Graben oder ein Loch in der Hilfsschicht I darstellt, wird beispielsweise eine (nicht dargestellte) Resistschicht ausgebildet und anschließend mittels herkömmlicher fotolithographischer Verfahren strukturiert. Anschließend wird zumindest ein Teil der Hilfsschicht I unter Verwendung der (nicht dargestellten) strukturierten Resistschicht entfernt, wobei gemäß Figur 5A die Hilfsschicht I vollständig bis zum Trägermaterial T entfernt wird und somit ein tiefer Graben bzw. ein tiefes Loch als Vertiefung V entsteht. Abschließend wird die Resistschicht entfernt und eventuell ein Reinigungsschritt (Post Cleaning) zum Entfernen von eventuell entstandenen Verunreinigungen durchgeführt. Vorzugsweise wird zum Ausbilden der Vertiefung ein anisotropes Ätzen wie z.B. reaktives Ionenätzen (RIE, Reactive Ion Etch) durchgeführt, wodurch man im Wesentlichen senkrechte Wände der Vertiefung V erhält.

Gemäß Figur 58 wird in einem nachfolgenden Schritt die Vertiefung V mit einem ersten elektrisch leitenden Material zum Ausbilden einer ersten Elektrode 1 aufgefüllt, wobei beispielsweise ein chemisches Abscheideverfahren (CVD, Chemical Vapor Deposition) eines Metalls wie z.B. Wolfram derart an der Oberfläche der Hilfsschicht I durchgeführt wird, dass sich im Bereich der Vertiefung V nunmehr eine angepasste Vertiefung VV im abgeschiedenen Material 1 ergibt.

Wie bereits vorstehend beschrieben wurde, kann als elektrisch leitendes Material für die erste Elektrode 1 auch ein Material aus der oben genannten Tabelle ausgewählt oder anderweitig ausgebildet werden.

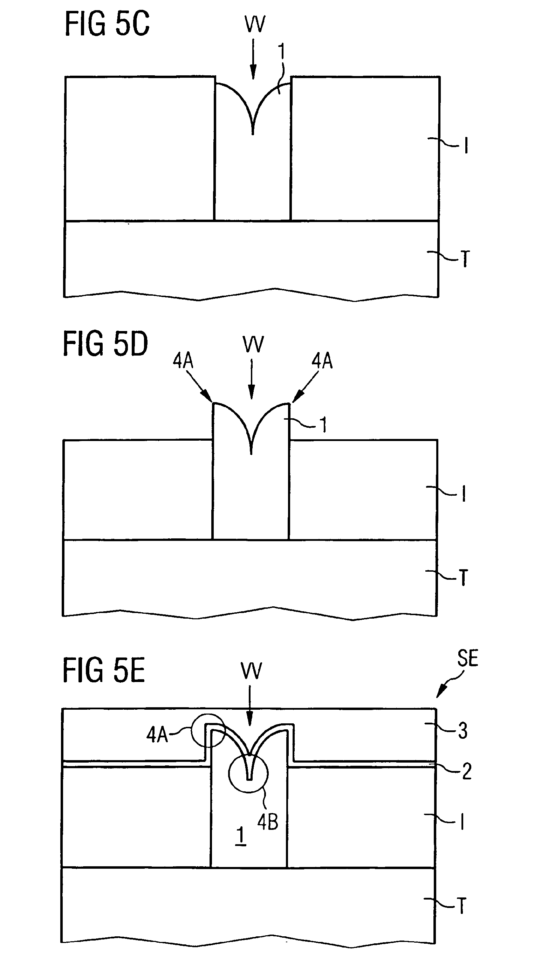

Gemäß Figur 5C wird in einem nachfolgenden Verfahrensschritt das elektrisch leitende Material 1 zumindest bis zur Oberfläche der Hilfsschicht I konformal, d.h. gleich stark zur Ausgangsoberfläche zurückgebildet, wobei insbesondere ein anisotropes Ätzverfahren als Rückätzschritt durchgeführt wird und sich somit die in Figur 5C dargestellte Struktur für die erste Elektrode 1 ergibt. Die angepasste Vertiefung VV wird demzufolge unverändert übernommen bzw. in die Vertiefung V transformiert.

Gemäß Figur 5D wird anschließend die Hilfsschicht I derart zurückgebildet, dass sich die Spitzen 4A als Feldverstärkerstruktur in der ersten Elektrode 1 ergeben und über die Hilfsschicht I ausreichend hinausragen. Vorzugsweise wird die Hilfsschicht im Wesentlichen bis zu einer Höhe des Bodenbereichs der angepassten Vertiefung VV zurückgeätzt, wodurch man eine optimierte Ausbildung der Spitzen bzw. Ecken oder Kanten (im Falle eines Grabens) erhält. Dieser Rückbildungsprozess der Hilfsschicht I ist vorzugsweise wiederum ein anisotroper Rückätzschritt selektiv zum Material der ersten Elektrode 1.

Abschließend wird gemäß Figur 5E auf der ersten Elektrode 1 mit ihrer darin ausgebildeten Feldverstärkerstruktur 4A ein Umschaltmaterial 2 ausgebildet, wobei wiederum als Materialien die in der oben genannten Tabelle verwendeten Materialien oder Mehrfach-Schichtstrukturen verwendet werden können. Vorzugsweise wird hierbei eine Abscheidung von wasserstoffgesättigtem amorphem Silizium oder einer entsprechenden Mehrfachschicht durchgeführt.

Zur Vervollständigung des nichtflüchtigen Speicherelements SE wird schließlich an der Oberfläche des Umschaltmaterials 2 eine zweite elektrisch leitende Elektrode 3 ausgebildet, wobei wiederum die in der oben genannten Tabelle aufgeführten Materialien grundsätzlich zur Verfügung stehen. In Abhängigkeit von einer jeweiligen Anwendung können nachfolgend eine Planarisierung und/oder Strukturierung der zweiten elektrisch leitenden Elektrode 3 durchgeführt werden.

Beispielsweise erfolgt das Ausbilden der zweiten Elektrode 3 durch Abscheiden einer metallhaltigen Schicht.

### Viertes Ausführungsbeispiel

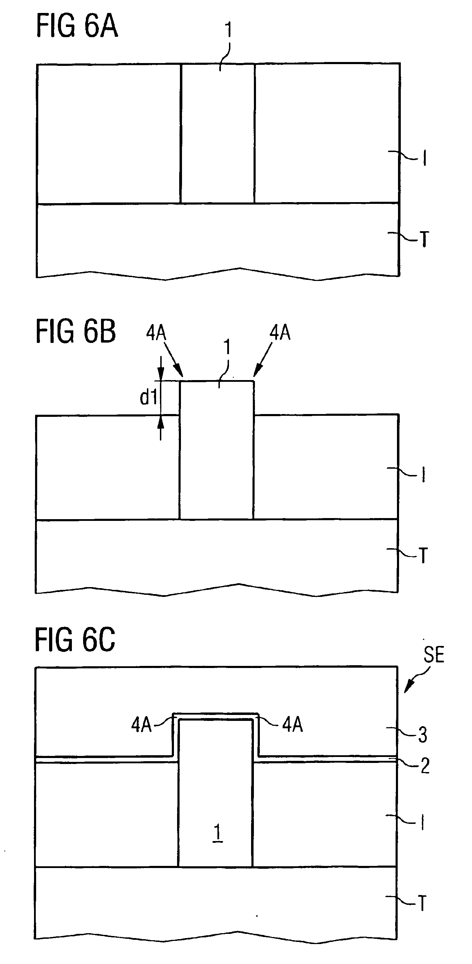

Figuren 6A bis 6C zeigen vereinfachte Schnittansichten wesentlicher Verfahrensschritte bei der Herstellung eines nichtflüchtigen Speicherelements gemäß einem vierten Ausführungsbeispiel, wobei gleiche Bezugszeichen gleiche Schichten oder Elemente bezeichnen wie in den Figuren 1 bis 4 und auf eine wiederholte Beschreibung nachfolgend verzichtet wird.

Gemäß diesem vierten Ausführungsbeispiel werden wiederum die vorbereitenden Verfahrensschritte gemäß Figuren 5A und 5B des dritten Ausführungsbeispiels durchgeführt, weshalb an dieser Stelle ausdrücklich auf die entsprechende Beschreibung verwiesen wird.

Gemäß Figur 6A wird im vorliegenden vierten Ausführungsbeispiel nach dem Auffüllen der Vertiefung V mit einem ersten elektrisch leitenden Material zum Ausbilden einer ersten Elektrode 1 (siehe Figur 5B) zunächst ein Planarisierverfahren zum Rückbilden des elektrisch leitenden Materials 1 zumindest bis zur Oberfläche der Hilfsschicht I durchgeführt. Vorzugsweise wird ein chemisch-mechanisches Polieren (CMP, Chemical Mechanical Polishing) der Wolframschicht 1 durchgeführt, wodurch man die in Figur 6A dargestellte Schnittansicht erhält.

Gemäß Figur 6B wird anschließend die Hilfsschicht I um einen vorbestimmten Betrag d1 zurückgebildet, wobei beispielsweise ein selektiver Rückätzschritt zum Freilegen der ersten Elektrode 1 und der darin ausgebildeten Kanten 4A als Feldverstärkerstruktur erfolgt.

Gemäß Figur 6C wird wie im dritten Ausführungsbeispiel wiederum ein Umschaltmaterial 2 an der Oberfläche der Hilfsschicht I und der ersten Elektrode 1 ausgebildet und abschließend die zweite elektrisch leitende Elektrode 3 darauf ausgebildet, wodurch man ein nichtflüchtiges Speicherelement mit verringerten Formierungs-Spannungen erhält. Die Feldverstärkerstrukturen liegen hierbei in den rechtwinkligen Kanten 4A der ersten Elektrode 1. Hinsichtlich des Ausbildevorgangs der Umschaltmaterialschicht 2 und der zweiten Elektrode 3 wird an dieser Stelle ausdrücklich auf das dritte Ausführungsbeispiel verwiesen.

### Fünftes Ausführungsbeispiel

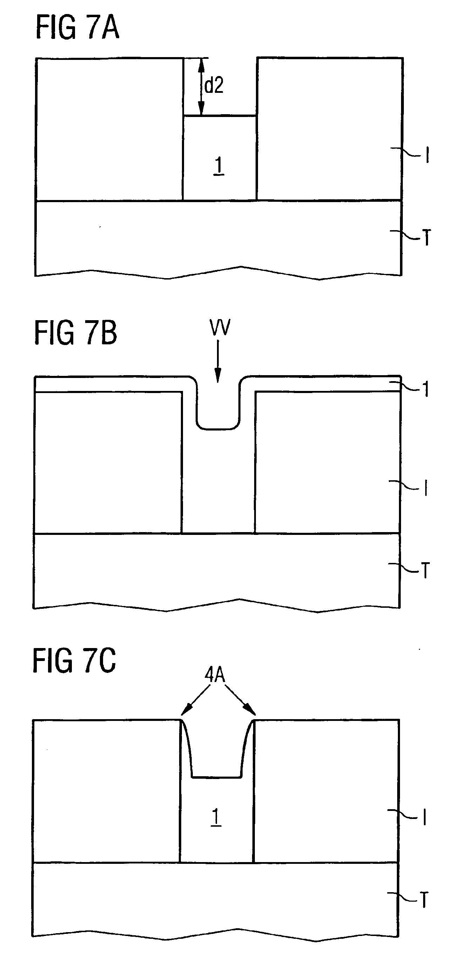

Figuren 7A bis 7D zeigen vereinfachte Schnittansichten zur Veranschaulichung wesentlicher Verfahrensschritte bei der Herstellung eines nichtflüchtigen Speicherelements gemäß einem fünften Ausführungsbeispiel, wobei gleiche Bezugszeichen gleiche Schichten oder Elemente bezeichnen wie in Figuren 1 bis 6 und auf eine wiederholte Beschreibung nachfolgend verzichtet wird.

Gemäß Figur 7A wird nach vorbereitenden Schritten, wie sie beispielsweise in den Figuren 5A und 5B oder 6A dargestellt sind, zunächst ein vorbestimmter Betrag (d2) des elektrisch leitenden Materials 1 der ersten Elektrode in der Vertiefung V entfernt. Vorzugsweise wird hierbei ein herkömmliches Ätzverfahren zum Rückätzen der elektrisch leitenden Schicht 1 verwendet.

Gemäß Figur 7B wird anschließend eine dünne konformale elektrisch leitende Schicht derart ausgebildet, dass eine angepasste Vertiefung VV im Bereich der Vertiefung V verbleibt. Vorzugsweise besteht die konformal, d.h. mit gleicher Dicke zur Bezugsoberfläche, ausgebildete Schicht aus dem gleichen Material wie das erste elektrisch leitende Material 1, wobei jedoch auch andere elektrisch leitende Materialien aufgebracht werden können und sich dadurch eine Mehrfach-Schichtstruktur für die erste Elektrode ergibt.

Gemäß Figur 7C wird nachfolgend durch ein anisotropes Ätzverfahren die konformal ausgebildete elektrisch leitende Schicht bzw. die darunter liegende elektrisch leitende Schicht zumindest bis zur Oberfläche der Hilfsschicht I zurückgebildet bzw. zurückgeätzt, wodurch man die Spitzen 4A erhält. Vorzugsweise werden zur Ausbildung der Spitzen 4A in der ersten Elektrode 1 herkömmliche Spacer-Verfahren in den Figuren 7B und 7C durchgeführt.

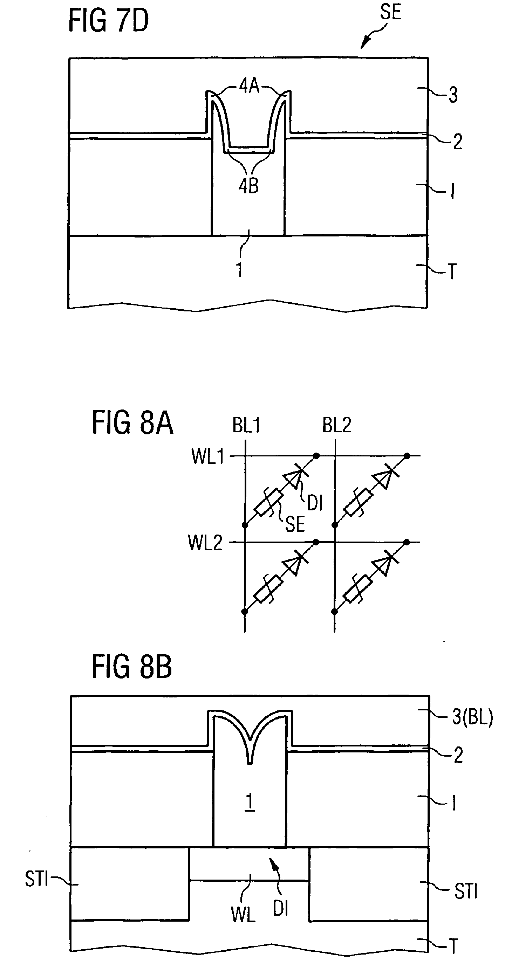

Gemäß Figur 7D erfolgt wiederum der in den Figuren 6B und 6C beschriebene Verfahrensablauf, wobei beispielsweise mittels eines anisotropen Ätzverfahrens die Hilfsschicht I im Wesentlichen bis zum Bodenbereich der angepassten Vertiefung VV zurückgeätzt wird und anschließend die Umschaltmaterial-Schicht 2 und die zweite Elektrode 3 ausgebildet werden. Zur Vermeidung von Wiederholungen wird an dieser Stelle wiederum auf die jeweiligen Beschreibungen der vorhergehenden Ausführungsbeispiele verwiesen.

Auf diese Weise kann mit sehr einfachen Herstellungsschritten ein nichtflüchtiges Speicherelement SE mit Feldverstärkerstrukturen geschaffen werden, wodurch sich insbesondere sogenannte Formierungs-Spannungen wesentlich reduzieren lassen.

Nachfolgend werden typische Speicherelementanordnungen beispielhaft aufgeführt, die mit den vorstehend beschriebenen nichtflüchtigen Speicherelementen zur Realisierung eines nichtflüchtigen Speichers ausgebildet werden können.

### Sechstes Ausführungsbeispiel

Figur 8A zeigt ein vereinfachtes Ersatzschaltbild einer Speicherelementanordnung unter Verwendung eines nichtflüchtigen Speicherelements gemäß einem sechsten Ausführungsbeispiel, wie es in Figur 8B in einer vereinfachten Schnittansicht dargestellt ist.

Gemäß Figur 8B sind im Trägermaterial T, welches beispielsweise ein Halbleitermaterial aufweist, Wortleitungen WL beispielsweise durch Dotiergebiete ausgebildet, die mittels flacher Grabenisolierung STI (Shallow Trench Isolation) voneinander isoliert bzw. getrennt sind. Der weitere Speicherelementaufbau entspricht dem des Speicherelements gemäß dem dritten Ausführungsbeispiel, wobei das Material der ersten Elektrode 1 derart gewählt ist, dass es mit der Wortleitung WL bzw. dem Dotiergebiet einen Diodenübergang bzw. eine Schottky-Diode bildet.

Figur 8A zeigt eine Speicherelementanordnung mit einer Vielzahl von matrixförmig angeordneten nichtflüchtigen Speicherelementen SE und zugehörigen Dioden DI, die über spaltenförmig angeordnete Bitleitungen BL1, BL2 usw. und zeilenförmig angeordnete Wortleitungen WL1, WL2 usw. ansteuerbar sind, wobei die erste Elektrode 1 über einen jeweiligen Diodenübergang bzw. eine Diode DI mit einer jeweiligen im Halbleitersubstrat T ausgebildeten Wortleitung elektrisch verbunden ist und eine jeweilige zweite Elektrode 3 zum Ausbilden einer jeweiligen Bitleitung BL streifenförmig an der Oberfläche der Hilfsschicht I strukturiert ist. Auf diese Weise erhält man eine Speicherelementanordnung mit außerordentlich hoher Integrationsdichte, die mit geringen Formierungs-Spannungen vorbereitet werden kann.

### Siebtes Ausführungsbeispiel

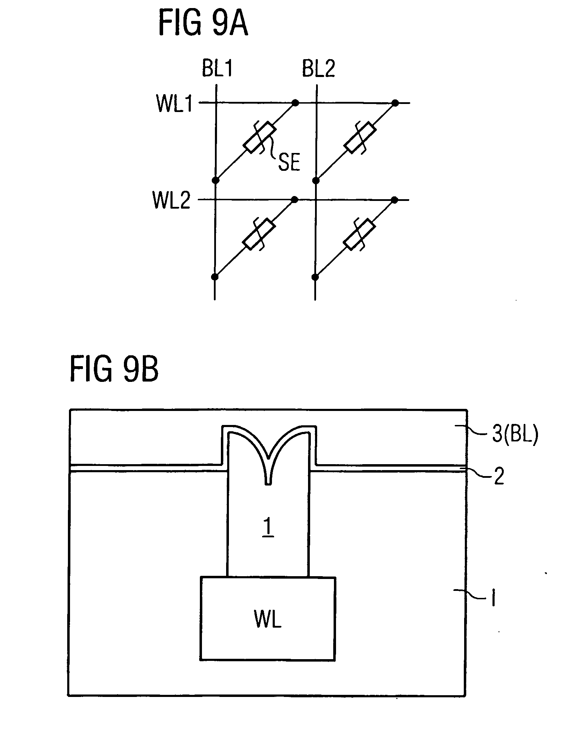

Figur 9A zeigt ein vereinfachtes Ersatzschaltbild einer Speicherelementanordnung unter Verwendung eines nichtflüchtigen Speicherelements gemäß einem siebten Ausführungsbeispiel, wie es in Figur 9B in einer vereinfachten Schnittansicht dargestellt ist, wobei gleiche Bezugszeichen gleiche oder entsprechende Elemente wie in Figur 8 bezeichnen und auf eine wiederholte Beschreibung verzichtet wird.

Gemäß Figur 9B besteht ein jeweiliges nichtflüchtiges Speicherelement aus einer ersten Elektrode 1, die nunmehr über einen ohmschen Übergang bzw. einen ohmschen Widerstand unmittelbar mit einer jeweiligen elektrisch leitfähigen Wortleitung WL elektrisch verbunden ist, und einer jeweiligen zweite Elektrode 3, die wiederum zum Ausbilden der Bitleitung BL streifenförmig an der Oberfläche der Hilfsschicht I strukturiert ist.

### Achtes Ausführungsbeispiel

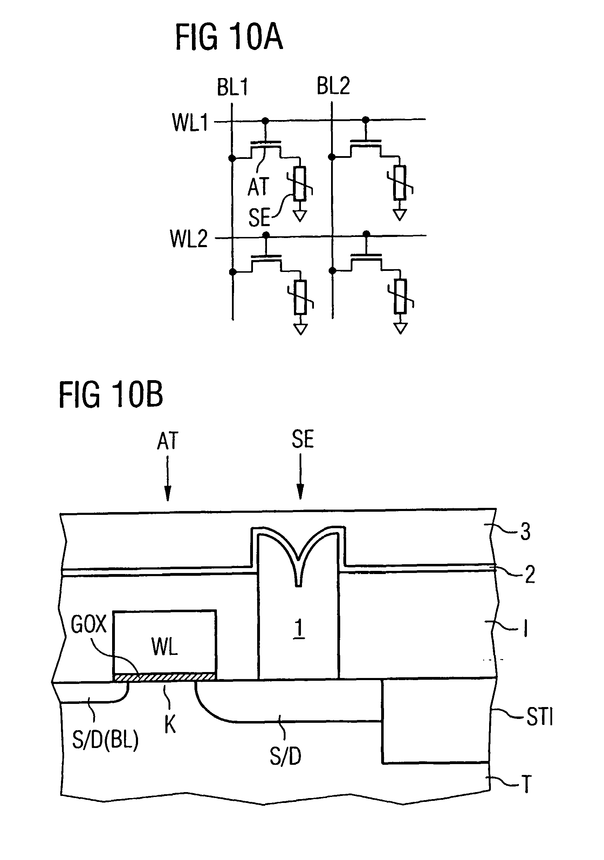

Figur 10A zeigt ein vereinfachtes Ersatzschaltbild zur Veranschaulichung einer Speicherelementanordnung unter Verwendung eines nichtflüchtigen Speicherelements gemäß einem achten Ausführungsbeispiel, wie es in Figur 10B in einer vereinfachten Schnittansicht dargestellt ist, wobei gleiche Bezugszeichen gleiche oder entsprechende Elemente wie in Figuren 8 und 9 bezeichnen und auf eine wiederholte Beschreibung verzichtet wird.

Gemäß der in Figur 10B dargestellten Schnittansicht wird bei einer derartigen Speicherelementanordnung für jedes nichtflüchtige Speicherelement SE ein zugehöriger Auswahltransistor AT mit einer als Steuerschicht dienenden Wortleitung WL und einer als erstes Source-/Draingebiet S/D dienenden Bitleitung BL im Halbleitersubstrat T ausgebildet, wobei ein zweites Source-/Draingebiet S/D des Auswahltransistors AT mit einer jeweiligen ersten Elektrode 1 des nichtflüchtigen Speicherelements SE verbunden ist und eine jeweilige zweite Elektrode 3 auf einem gemeinsamen Bezugspotential (z.B. Common Source) liegt. Wiederum ergeben sich für ein bestimmtes Anwendungsgebiet besonders einfach zu realisierende Speicherelementanordnungen mit minimalem Flächenbedarf und wesentlich verringerten Formierungs-Spannungen. Bekanntermaßen erhält man ein deutlich verbessertes Signal-Rausch Verhältnis, wenn man einen seriellen Auswahltransistor dazufügt. Dadurch ist es möglich deutlich größere Zellenfelder bzw. Sektoren zu gestalten.

Die Erfindung wurde vorstehend anhand ausgewählter Materialien beschrieben und insbesondere anhand von wasserstoffgesättigtem amorphem Silizium als Umschaltmaterial. Sie ist jedoch nicht darauf beschränkt und umfasst in gleicher Weise alternative Materialien zur Realisierung eines nichtflüchtigen Speicherelements mit zumindest zwei verschiedenen Leitfähigkeitszuständen nach einem Formierungs-Schritt.

## Patentansprüche

1. Nichtflüchtiges Speicherelement mit einem Umschaltmaterial (2) und zwei am Umschaltmaterial (2) anliegenden elektrisch leitenden Elektroden (1, 3) zum Anlegen einer Spannung und Erzeugen eines elektrischen Feldes (E) im Umschaltmaterial (2), wobei nach einem Formierungs-Schritt zumindest zwei verschiedene Leitfähigkeitszustände (ON, OFF) im Umschaltmaterial (2) vorherrschen, zwischen denen durch Anlegen vorbestimmter Programmierspannungen (V_{schreib}, V_{lögsch}) wiederholt umgeschaltet.werden kann,
**dadurch gekennzeichnet, dass** zumindest eine der Elektroden (1, 3) zumindest eine Feldverstärkerstruktur (4) zum Verstärken einer Feldstärke des elektrischen Feldes (E) im Umschaltmaterial (2) aufweist.

2. Nichtflüchtiges Speicherelement nach Patentanspruch 1,
**dadurch gekennzeichnet, dass** die Feldverstärkerstruktur einen in das Umschaltmaterial (2) ragenden Vorsprung der Elektroden (1, 3) darstellt.

3. Nichtflüchtiges Speicherelement nach Patentanspruch 2,
**dadurch gekennzeichnet, dass** der Vorsprung eine Spitze, Ecke oder Kante der Elektroden (1, 3) darstellt.

4. Nichtflüchtiges Speicherelement nach Patentanspruch 3,
**dadurch gekennzeichnet, dass** ein Winkel der Spitze, Ecke oder Kante ≤ 90 Grad ist.

5. Nichtflüchtiges Speicherelement nach einem der Patentansprüche 1 bis 4,
**dadurch gekennzeichnet, dass** das Umschaltmaterial (2) ein wasserstoffgesättigtes amorphes Halbleitermaterial aufweist.

6. Nichtflüchtiges Speicherelement nach einem der Patentansprüche 1 bis 5,
**dadurch gekennzeichnet, dass** das Umschaltmaterial (2) einen Mehrschichtaufbau (2A, 2B, 2C) aufweist.

7. Nichtflüchtiges Speicherelement nach einem der Patentansprüche 1 bis 5,
**dadurch gekennzeichnet, dass** die Elektroden (1, 3) ein Metall aufweisen.

8. Verfahren zur Herstellung eines nichtflüchtigen Speicherelements mit den Schritten:
a) Vorbereiten eines Trägermaterials (T);
b) Ausbilden einer Hilfsschicht (I);
c) Ausbilden einer Vertiefung (V) in der Hilfsschicht (I);
d) Auffüllen der Vertiefung (V) mit einem ersten elektrisch leitenden Material zum Ausbilden einer ersten Elektrode (1);
e) Ausbilden von zumindest einer Feldverstärkerstruktur (4A) an der ersten Elektrode (1);
f) Ausbilden eines Umschaltmaterials (2) auf der ersten Elektrode (1) mit der Feldverstärkerstruktur (4A), wobei nach einem Formierungs-Schritt zumindest zwei verschiedene Leitfähigkeitszustände (ON, OFF) im Umschaltmaterial (2) vorherrschen, zwischen denen durch Anlegen vorbestimmter Programmierspannungen (V_{schreib}, V_{lösch}) wiederholt umgeschaltet werden kann; und
g) Ausbilden einer zweiten elektrisch leitenden Elektrode (3) auf dem Umschaltmaterial (2).

9. Verfahren nach Patentanspruch 8,
**dadurch gekennzeichnet, dass** in Schritt a) ein Halbleitersubstrat als Trägermaterial (T) vorbereitet wird.

10. Verfahren nach Patentanspruch 8 oder 9,
**dadurch gekennzeichnet, dass** in Schritt a) eine Wortleitung (WL) im Trägermaterial (T) im Bereich der Vertiefung (V) ausgebildet wird, wobei die Wortleitung (WL) ein Material aufweist, das mit dem Material der ersten Elektrode (1) einen ohmschen- oder Dioden-Übergang (DI) realisiert.

11. Verfahren nach Patentanspruch 8 oder 9,
**dadurch gekennzeichnet, dass** in Schritt a) ein Auswahltransistor (AT) mit Source-/Draingebieten (S/D) im Trägermaterial (T) ausgebildet wird, wobei die Source/Draingebiete (S/D) jeweils eine Bitleitung (BL) und ein Anschlussgebiet für die erste Elektrode (1) realisieren.

12. Verfahren nach einem der Patentansprüche 8 bis 11,
**dadurch gekennzeichnet, dass** in Schritt b) eine Isolatorschicht (I) ganzflächig auf dem Trägermaterial (T) abgeschieden wird.

13. Verfahren nach einem der Patentansprüche 8 bis 12,
**dadurch gekennzeichnet, dass** in Schritt c)
eine Resistschicht ausgebildet und strukturiert wird; zumindest ein Teil der Hilfsschicht (I) unter Verwendung der strukturierten Resistschicht entfernt wird;
die Resistschicht entfernt wird; und
ein Reinigungsschritt durchgeführt wird.

14. Verfahren nach Patentanspruch 13,
**dadurch gekennzeichnet, dass**
in Schritt c) zum zumindest teilweise Entfernen der Hilfsschicht (I) ein anisotropes Ätzen durchgeführt wird.

15. Verfahren nach einem der Patentansprüche 8 bis 14,
**dadurch gekennzeichnet, dass**
in Schritt c) ein Graben oder ein Loch als Vertiefung (V) ausgebildet wird.

16. Verfahren nach einem der Patentansprüche 8 bis 15,
**dadurch gekennzeichnet, dass**
in Schritt d) das elektrisch leitende Material (1) derart abgeschieden wird, dass sich im Bereich der Vertiefung (V) eine angepasste Vertiefung (VV) ergibt.

17. Verfahren nach Patentanspruch 16,
**dadurch gekennzeichnet, dass** in Schritt e)
e11) mittels eines anisotropen Ätzverfahrens das elektrisch leitende Material (1) zumindest bis zur Oberfläche der Hilfsschicht (I) konformal zurückgeätzt wird; und
e12) mittels eines anisotropen Ätzverfahrens die Hilfsschicht (I) im Wesentlichen bis zum Bodenbereich der angepassten Vertiefung (VV) zurückgeätzt wird.

18. Verfahren nach einem der Patentansprüche 8 bis 16,
**dadurch gekennzeichnet, dass** in Schritt e)
e21) mittels eines Planarisierverfahrens das elektrisch leitende Material (1) zumindest bis zur Oberfläche der Hilfsschicht (I) zurückgebildet wird; und
e22) mittels eines selektiven Ätzverfahrens die Hilfsschicht (I) um einen vorbestimmten Betrag (d1) zurückgeätzt wird.

19. Verfahren nach einem der Patentansprüche 8 bis 16,
**dadurch gekennzeichnet, dass** in Schritt e)
e31) mittels eines Ätzverfahrens zumindest ein vorbestimmter Betrag (d2) des elektrisch leitenden Materials (1) in der Vertiefung (V) entfernt;
e32) ein Ausbilden einer dünnen konformalen elektrisch leitenden Schicht derart durchgeführt wird, dass eine angepasste Vertiefung (VV) im Bereich der Vertiefung (V) verbleibt;
e33) mittels eines anisotropen Ätzverfahrens die elektrisch leitende Schicht (1) zumindest bis zur Oberfläche der Hilfsschicht (I) zurückgeätzt wird; und
e34) mittels eines anisotropen Ätzverfahrens die Hilfsschicht (I) im Wesentlichen bis zum Bodenbereich der angepassten Vertiefung (VV) zurückgeätzt wird.

20. Verfahren nach einem der Patentansprüche 8 bis 19,
**dadurch gekennzeichnet, dass**
in Schritt f) eine einfache oder mehrfache wasserstoffgesättigte, amorphe Halbleiterschicht auf der ersten Elektrode (1) mit der Feldverstärkerstruktur (4; 4A, 4B) abgeschieden wird.

21. Verfahren nach einem der Patentansprüche 8 bis 20,
**dadurch gekennzeichnet, dass**
in Schritt g) eine Cr-, Au-, A1-, Cu-, NiCr-, Ag-, Ni-, Mo-, V-, Co-, Fe-, W- oder Mn-Schicht als zweite Elektrode (3) abgeschieden wird.

22. Speicherelementanordnung mit einer Vielzahl von matrixförmig angeordneten nichtflüchtigen Speicherelementen nach einem der Patentansprüche 1 bis 7, die über spaltenförmig angeordnete Bitleitungen (BL) und zeilenförmig angeordnete Wortleitungen (WL) ansteuerbar sind,
**dadurch gekennzeichnet, dass** eine jeweilige erste Elektrode (1) über einen Diodenübergang (DI) mit einer jeweiligen in einem Halbleitersubstrat (T) ausgebildeten Wortleitung (WL) elektrisch verbunden ist und
eine jeweilige zweite Elektrode (3) zum Ausbilden einer jeweiligen Bitleitung (BL) streifenförmig an der Oberfläche der Hilfsschicht (I) strukturiert ist.

23. Speicherelementanordnung mit einer Vielzahl von matrixförmig angeordneten nichtflüchtigen Speicherelementen nach einem der Patentansprüche 1 bis 7, die über spaltenförmig angeordnete Bitleitungen (BL) und zeilenförmig angeordnete Wortleitungen (WL) ansteuerbar sind,
**dadurch gekennzeichnet, dass** eine jeweilige erste Elektrode (1) über einen ohmschen Übergang mit einer jeweiligen in einem Halbleitersubstrat (T) ausgebildeten Wortleitung (WL) elektrisch verbunden ist, und
eine jeweilige zweite Elektrode (3) zum Ausbilden der jeweiligen Bitleitung (BL) streifenförmig an der Oberfläche der Hilfsschicht (I) strukturiert ist.

24. Speicherelementanordnung mit einer Vielzahl von matrixförmig angeordneten nichtflüchtigen Speicherelementen nach einem der Patentansprüche 1 bis 7, die über spaltenförmig angeordnete Bitleitungen (BL) und zeilenförmig angeordnete Wortleitungen (WL) ansteuerbar sind,
**dadurch gekennzeichnet, dass** jedes Speicherelement (SE) einen Auswahltransistor (AT) mit einer als Steuerschicht dienenden Wortleitung (WL) und einer als erstes Source-/Draingebiet (S/D) dienenden Bitleitung (BL) im Halbleitersubstrat (T) ausgebildet ist, wobei ein zweites Source-/Draingebiet (S/D) des Auswahltransistors (AT) mit einer ersten Elektrode (1) des Speicherelements (SE) elektrisch verbunden ist und eine jeweilige zweite Elektrode (3) auf einem gemeinsamen Potential liegt.

## Claims

1. Nonvolatile memory element having a changeover material (2) and two electrically conductive electrodes (1, 3) present at the changeover material (2) and serving for the application of a voltage and generation of an electric field (E) in the changeover material (2), after a forming step at least two different conductivity states (ON, OFF) prevailing in the changeover material (2), between which changeover can be repeatedly effected by the application of predetermined programming voltages (V_{write}, Vₑᵣₐₛₑ),
**characterized in that** at least one of the electrodes (1, 3) has at least one field amplifier structure (4) for amplifying a field strength of the electric field (E) in the changeover material (2).

2. Nonvolatile memory element according to Patent Claim 1, **characterized in that** the field amplifier structure constitutes a projection of the electrodes (1, 3) which projects into the changeover material (2).

3. Nonvolatile memory element according to Patent Claim 2, **characterized in that** the projection constitutes a tip, corner or edge of the electrodes (1, 3).

4. Nonvolatile memory element according to Patent Claim 3, **characterized in that** an angle of the tip, corner or edge is ≤ 90 degrees.

5. Nonvolatile memory element according to one of Patent Claims 1 to 4,
**characterized in that** the changeover material (2) has a hydrogen-saturated amorphous semiconductor material.

6. Nonvolatile memory element according to one of Patent Claims 1 to 5,
**characterized in that** the changeover material (2) has a multilayer construction (2A, 2B, 2C).

7. Nonvolatile memory element according to one of Patent Claims 1 to 5,
**characterized in that** the electrodes (1, 3) have a metal.

8. Method for producing a nonvolatile memory element having the following steps:
a) preparation of a carrier material (T);
b) formation of an auxiliary layer (I);
c) formation of a depression (V) in the auxiliary layer (I);
d) filling of the depression (V) with a first electrically conductive material for forming a first electrode (1);
e) formation of at least one field amplifier structure (4A) at the first electrode (1);
f) formation of a changeover material (2) on the first electrode (1) with the field amplifier structure (4A), after a forming step at least two different conductivity states (ON, OFF) prevailing in the changeover material (2), between which changeover can be repeatedly effected by the application of predetermined programming voltages (V_{write}, Vₑᵣₐₛₑ); and
g) formation of a second electrically conductive electrode (3) on the changeover material (2).

9. Method according to Patent Claim 8,
**characterized in that**, in step a), a semiconductor substrate is prepared as carrier material (T).

10. Method according to Patent Claim 8 or 9,
**characterized in that**, in step a), a word line (WL) is formed in the carrier material (T) in the region of the depression (V), the word line (WL) having a material which realizes an ohmic or diode junction (DI) with the material of the first electrode (1).

11. Method according to Patent Claim 8 or 9,
**characterized in that**, in step a), a selection transistor (AT) having source/drain regions (S/D) is formed in the carrier material (T), the source/drain regions (S/D) in each case realizing a bit line (BL) and a terminal region for the first electrode (1).

12. Method according to one of Patent Claims 8 to 11,
**characterized in that**, in step b), an insulator layer (I) is deposited over the whole area on the carrier material (T).

13. Method according to one of Patent Claims 8 to 12,
**characterized in that**, in step c),
a resist layer is formed and patterned;
at least part of the auxiliary layer (I) is removed using the patterned resist layer;
the resist layer is removed; and
a cleaning step is carried out.

14. Method according to Patent Claim 13,
**characterized in that**,
in step c), an anisotropic etching is carried out for the at least partial removal of the auxiliary layer (I).

15. Method according to one of Patent Claims 8 to 14,
**characterized in that**,
in step c), a trench or a hole is formed as depression (V).

16. Method according to one of Patent Claims 8 to 15,
**characterized in that**,
in step d), the electrically conductive material (1) is deposited in such a way that an adapted depression (VV) is produced in the region of the depression (V).

17. Method according to Patent Claim 16,
**characterized in that**,
in step e),
e11) the electrically conductive material (1) is etched back conformally at least as far as the surface of the auxiliary layer (I) by means of an anisotropic etching method; and
e12) the auxiliary layer (I) is etched back essentially as far as the bottom region of the adapted depression (VV) by means of an anisotropic etching method.

18. Method according to one of Patent Claims 8 to 16,
**characterized in that**,
in step e),
e21) the electrically conductive material (1) is caused to recede at least as far as the surface of the auxiliary layer (I) by means of a planarization method; and
e22) the auxiliary layer (I) is etched back by a predetermined amount (d1) by means of a selective etching method.

19. Method according to one of Patent Claims 8 to 16,
**characterized in that**,
in step e),
e31) at least a predetermined amount (d2) of the electrically conductive material (1) is removed in the depression (V) by means of an etching method;
e32) a formation of a thin conformal electrically conductive layer is carried out in such a way that an adapted depression (VV) remains in the region of the depression (V);
e33) the electrically conductive layer (1) is etched back at least as far as the surface of the auxiliary layer (I) by means of an anisotropic etching method; and
e34) the auxiliary layer (I) is etched back essentially as far as the bottom region of the adapted depression (VV) by means of an anisotropic etching method.

20. Method according to one of Patent Claims 8 to 19,
**characterized in that**,
in step f), a single or multiple hydrogen-saturated, amorphous semiconductor layer is deposited on the first electrode (1) with the field amplifier structure (4; 4A, 4B).

21. Method according to one of Patent Claims 8 to 20,
**characterized in that**,
in step g), a Cr, Au, Al, Cu, NiCr, Ag, Ni, Mo, V, Co, Fe, W or Mn layer is deposited as second electrode (3).

22. Memory element arrangement having a multiplicity of nonvolatile memory elements according to one of Patent Claims 1 to 7 which are arranged in matrix form and can be addressed via bit lines (BL) arranged in column form and word lines (WL) arranged in row form,
**characterized in that** a respective first electrode (1) is electrically connected via a diode junction (DI) to a respective word line (WL) formed in a semiconductor substrate (T), and
a respective second electrode (3) for forming a respective bit line (BL) is patterned in strip form at the surface of the auxiliary layer (I).

23. Memory element arrangement having a multiplicity of nonvolatile memory elements according to one of Patent Claims 1 to 7 which are arranged in matrix form and can be addressed via bit lines (BL) arranged in column form and word lines (WL) arranged in row form,
**characterized in that** a respective first electrode (1) is electrically connected via an ohmic junction to a respective word line (WL) formed in a semiconductor substrate (T), and
a respective second electrode (3) for forming the respective bit line (BL) is patterned in strip form at the surface of the auxiliary layer (I).

24. Memory element arrangement having a multiplicity of nonvolatile memory elements according to one of Patent Claims 1 to 7 which are arranged in matrix form and can be addressed via bit lines (BL) arranged in column form and word lines (WL) arranged in row form,
**characterized in that** there is formed, for each memory element (SE), a selection transistor (AT) with a word line (WL) serving as control layer and a bit line (BL) serving as first source/drain region (S/D) in the semiconductor substrate (T), a second source/drain region (S/D) of the selection transistor (AT) being electrically connected to a first electrode (1) of the memory element (SE) and a respective second electrode (3) being at a common potential.

## Revendications

1. Elément de mémoire non volatil comprenant un matériau (2) de commutation et deux électrodes (1, 3) conductrice de l'électricité s'appliquant au matériau (2) de commutation pour appliquer une tension et produire un champ (E) électrique dans le matériau (2) de commutation, dans lequel, après un stade de formage, il prédomine dans le matériau (2) de commutation au moins deux états (ON, OFF) différents de conductivité, entre lesquels on peut commuter de manière répétée en appliquant des tensions (V_{schreib}, V_{lösch}) de programmation déterminées à l'avance,
**caractérisé en ce qu'**au moins l'une des électrodes (1, 3) a au moins une structure (4) d'amplification du champ pour amplifier une intensité du champ (E) électrique dans le matériau (2) de commutation.

2. Elément de mémoire non volatil suivant la revendication 1, **caractérisé en ce que** la structure d'amplification du champ constitue une saillie des électrodes (1,3) pénétrant dans le matériau (2) de commutation.

3. Elément de mémoire non volatil suivant la revendication 2, **caractérisé en ce que** la saillie constitue une pointe, un coin ou un bord des électrodes (1,3).

4. Elément de mémoire non volatil suivant la revendication 3, **caractérisé en ce qu'**un angle de la pointe, du coin ou du bord est ≤ à 90 degrés.

5. Elément de mémoire non volatil suivant la revendication 4, **caractérisé en ce que** le matériau (2) de commutation comporte un matériau semi-conducteur, amorphe et saturé d'hydrogène.

6. Elément de mémoire non volatil suivant l'une des revendications 1 à 5, **caractérisé en ce que** le matériau (2) de commutation a une structure (2A, 2B, 2C) stratifiée.

7. Elément de mémoire non volatil suivant l'une des revendications 1 à 5, **caractérisé en ce que** les électrodes (1, 3) comportent un métal.

8. Procédé de production d'un élément de mémoire non volatil, comprenant les stades dans lesquels :
a) on prépare un matériau (T) de support ;
b) on forme une couche (I) auxiliaire ;
c) on forme une cavité (V) dans la couche (I) auxiliaire ;
d) on rempli la cavité (V) d'un premier matériau conducteur de l'électricité pour former une première électrode (1) ;
e) on forme au moins une structure (4A) d'amplification du champ sur la première électrode (1) ;
f) on forme un matériau (2) de commutation sur la première électrode ayant la structure (4A) d'amplification du champ, dans lequel, après un stade de formage, il prédomine dans le matériau (2) de commutation au moins deux états (ON, OFF) différents de conductivité, entre lesquels on peut commuter de manière répétée en appliquant des tensions (U_{schreib}, V_{lösch}) de programmation déterminée à l'avance, et
g) on forme une deuxième électrode (3) conductrice d'électricité sur le matériau (2) de commutation.

9. Procédé suivant la revendication 8, **caractérisé en ce qu'**au stade a), on prépare un substrat semi-conducteur comme matériau (T) de support.

10. Procédé suivant la revendication 8 ou 9, **caractérisé en ce qu'**au stade a), on forme une ligne (WL) de mot dans le matériau (T) de support dans la zone de la cavité (V), la ligne (WL) de mot comportant un matériau qui réalise une jonction (DI) ohmique ou de diode avec le matériau de la première électrode (1).

11. Procédé suivant la revendication 8 ou 9, **caractérisé en ce qu'**au stade a) on forme un transistor (AT) de sélection ayant des zones (S/D) de source/drain dans le matériau (T) de support, les zones (S/D) de source/drain réalisant respectivement une ligne (BL) de bit et une zone de connexion de la première électrode (1).

12. Procédé suivant l'une des revendications 8 à 11, **caractérisé en ce qu'**au stade b), on dépose une couche (I) isolante sur toute la surface du matériau (T) de support.

13. Procédé suivant l'une des revendications 8 à 12, **caractérisé en ce qu'**au stade c),
on forme une couche de réserve et on la structure ;
on élimine au moins une partie de la couche (I) auxiliaire en utilisant la couche de réserve structurée;
on élimine la couche de réserve ; et
on effectue un stade de nettoyage.

14. Procédé suivant la revendication 13,
**caractérisé en ce que**,
au stade c), on effectue une attaque anisotrope pour éliminer au moins en partie la couche (I) auxiliaire.

15. Procédé suivant l'une revendications 8 à 14,
**caractérisé en ce que**,
au stade c), on forme un sillon ou un trou en tant que cavité (V).

16. Procédé suivant l'une revendications 8 à 15,
**caractérisé en ce que**,
au stade d), on dépose le matériau (1) un conducteur de l'électricité de manière à ce qu'il donne une cavité (VV) adaptée dans la zone de la cavité (V).

17. Procédé suivant la revendication 16,
**caractérisé en ce que**,
au stade e),
e11) on attaque en retrait de manière conforme au moyen d'un procédé d'attaque anisotrope le matériau (1) conducteur de l'électricité au moins jusqu'à la surface de la couche (I) auxiliaire ; et
e12) on attaque en retrait au moyen d'un procédé d'attaque anisotrope la couche (I) auxiliaire sensiblement jusqu'à la partie de fond de la cavité (VV) adaptée.

18. Procédé suivant l'une revendications 8 à 16,
**caractérisé en ce que**,
au stade e),
e21) on reforme au moyen d'un procédé de planarisation le matériau (1) conducteur d'électricité au moins jusqu'à la surface d'une couche (I) auxiliaire ; et
e22) on attaque en retrait au moyen d'un procédé d'attaque sélectif la couche (I) auxiliaire d'un montant (d1) déterminé à l'avance.

19. Procédé suivant l'une revendications 8 à 16,
**caractérisé en ce que**,
au stade e),
e31) on élimine au moyen d'un procédé d'attaque au moins un montant (d2) déterminé à l'avance du matériau (1) conducteur d'électricité dans la cavité (V) ;
e32) on effectue une formation d'une couche mince conforme et conductrice d'électricité de façon à laisser une cavité (VV) adaptée dans la zone de la cavité (V) ;
e33) au moyen d'un procédé d'attaque anisotrope, on attaque en retrait la couche (1) conductrice de l'électricité au moins jusqu'à la surface de la couche (I) auxiliaire ; et
e34) au moyen d'un procédé d'attaque anisotrope, on attaque en retrait la couche (I) auxiliaire sensiblement jusqu'à la zone de fond de la cavité (VV) adaptée.

20. Procédé suivant l'une revendications 8 à 19
**caractérisé en ce que**,
au stade f), on dépose une couche semi-conducteur, amorphe, simple ou multiple et saturée par de l'hydrogène sur la première électrode (1) ayant la structure (4, 4A à 4B) d'amplification du champ.

21. Procédé suivant l'une revendications 8 à 20,
**caractérisé en ce que**,
au stade g), on dépose un deuxième électrode (3) une couche de Cr, Au, Al, Cu, NiCr, Ag, Ni, Mo, V, Co, Fe, W ou Mn

22. Dispositif d'éléments de mémoire, ayant une pluralité d'éléments de mémoire non volatils disposés sous la forme d'une matrice suivant l'une des revendications 1 à 7, qui peuvent être commandés par des lignes (BL) de bit disposées sous forme de colonnes et par des lignes (WL) de mot disposées sous forme de lignes,
**caractérisé en ce qu'**une première électrode (1) respective est reliée électriquement par une jonction (DI) de diode à une ligne (WL) de mot formée respectivement dans un substrat (T) semi-conducteur et une deuxième électrode (3) respective est, pour former une ligne (BL) de bit respective, structurée en forme de bande à la surface de la couche (I) auxiliaire.

23. Dispositif d'éléments de mémoire, ayant une pluralité d'éléments de mémoire non volatil disposés sous la forme d'une matrice suivant l'une des revendications 1 à 7, qui peuvent être commandés par des lignes (BL) de bit disposées sous forme de colonnes et par des lignes (WL) de mots disposées sous forme de lignes,
**caractérisé en ce qu'**une première électrode (1) respective est reliée électriquement, par une jonction ohmique, à une ligne (WL) de mot respective formée dans un substrat (T) semi-conducteur, et
une deuxième électrode (3) respective est, pour former la ligne (BL) de bit respective, structurée en forme de bande à la surface de la couche (I) auxiliaire.

24. Dispositif d'éléments de mémoire, ayant une pluralité d'éléments de mémoire non volatil, disposés en forme de matrice suivant l'une des revendications 1 à 7, qui peuvent être commandée par des lignes (BL) de bit disposées sous forme de colonnes et par des lignes (WL) de mot disposées sous forme de lignes,
**caractérisé en ce que** chaque élément (SE) de mémoire est formé dans le substrat (T) semi-conducteur d'un transistor (AT) de sélection ayant une ligne (WL) de mot servant de couche de commande et une ligne (BL) de bit servant de première zone (S/D) de source/drain, une deuxième zone (S/D) de source/drain du transistor (AT) de sélection étant reliée électriquement à une première électrode (1) de l'élément (SE) de mémoire et une deuxième électrode (3) respective se trouvant à un potentiel commun.
